# EUROPEAN PATENT SPECIFICATION

(11) **EP 3 136 743 B1**
(45) Date of publication and mention of the grant of the patent: **11.10.2017**
(21) Application number: 15182225.1
(22) Date of filing: 24.08.2015
(51) Int. Cl.: H04Q 1/02, H05K 7/20

(54) **TORSION-RESISTANT HOUSING FOR AN ELECTRONIC APPARATUS**
VERWINDUNGSSTEIFES GEHÄUSE FÜR EINE ELEKTRONISCHE VORRICHTUNG
BOÎTIER RÉSISTANT À LA TORSION POUR UN APPAREIL ÉLECTRONIQUE

(43) Date of publication of application: 01.03.2017
(73) Proprietor: Rohde & Schwarz GmbH & Co. KG, 81671 München (DE)
(72) Inventor: Lasinger, Martin, 82054 Sauerlach (DE)
(74) Representative: Prinz & Partner mbB

(56) References cited:
- US-A1- 2002 149 911
- US-A1- 2006 141 921
- US-A1- 2010 110 631

## Description

The invention relates to a housing for an electronic apparatus, the housing being adapted for field use. The invention in particular relates to a housing for an electronic apparatus, having a bottom wall, a top wall and at least one side wall extending between the bottom wall and the top wall, at least one of the wall elements having a plurality of vent openings.

Housings for field use, in particular if the electronic apparatus arranged therein is heavy, shall be rigid so as to undergo very little deformation when being handled or subjected to the loads occurring during use.

It is known that closed housing walls contribute to a high rigidity against torsion as they have a high resistance to shear loads. This is in particular due to the fact that wall elements are particularly rigid against loads tending to displace the upper and the lower edge of the wall against each other.

The electronic apparatuses arranged within such housings however require cooling. Apart from active cooling systems which use a cooling liquid circuit, the majority of cooling systems requires openings in the housing so as to allow ambient air to enter into the housing and exit from the housing. These openings significantly reduce the rigidity of the housing, in particular if they are provided in the wall elements of the housing.

US 2002/0149911 which is considered to be the most relevant prior art, shows a housing of the type mentioned above, in which circular cooling openings are used (please see Figures 13 anad 16). These openings are arranged in rows and have different distances from each other.

The object of the invention is to provided a housing for an electronic apparatus which is distinguished by a high resistance to torsional loads while at the same time providing a large open cross section for entry or exit of cooling air.

This object is achieved in a housing as mentioned above, in which the vent openings have a generally elliptical shape and are arranged such that a plurality of straight, uninterrupted load paths is being formed which extend from an upper edge of the wall element to a lower edge thereof in a direction which is oriented obliquely with respect to the upper and the lower edge, respectively. The invention also provides a wall element for such housing.

The invention is based on the finding that a significant increase in the capacity of the wall element to carry shear loads can be achieved by using appropriately arranged openings. This increase in the load carrying capacity can either be used for increasing the available cross-section for the cooling air, or for increasing the rigidity of the housing.

Preferably, the upper edge and the lower edge of the wall element are provided with legs which extend at generally 90° with respect to a central body portion of the wall element so as to form a U-shaped girder. The legs at the upper edge and the lower edge of the wall element add additional strength to the wall element both regarding shear loads and buckling.

The wall element preferably has legs at the lateral edges, the legs extending at generally 90° with respect to a central body portion of the wall element. These legs are beneficial for connecting the wall element to adjacent elements of the housing.

In order to allow an efficient cooling of the electronic apparatus arranged within the housing, the total cross-section of the openings amounts to at least 30% of the surface of the wall element. Despite the fact that the wall element is largely perforated by the openings, the capacity of the wall element to carry shear loads is significant.

According to a preferred embodiment, the load paths extend at an angle of approx. 30° with respect to upper and lower edges, respectively. This value has proven to result in a high load carrying capacity of the wall element.

Preferably, the contour of the openings is a continuous one. In other words, the contour of the openings does not feature corners as corners would result in a stress concentration which is detrimental to a high load carrying capacity.

The contour of the housing can be composed of different segments which are easy to design. According to an embodiment, the contour comprises at least one parabolic arc. In the alternative, the contour is an ellipse. Openings with this contour can be engineered and manufactured easily.

According to a preferred embodiment, the length of the semi-major axis is twice the length of the semi-minor axis, and the distance between adjacent openings is twice the length of the semi-major axis. This value has proven to result in a good comprise between a high load carrying capacity of the wall element at the one hand and a large available cross-section of the openings on the other hand.

According to a preferred embodiment, the wall element is made from sheet metal. This material offers a high strength and a relatively low weight and can be machined easily. The openings can be formed by punching or cutting, e.g. with a laser beam or a water jet, and the edges of the wall element can easily be bent so as to form the legs.

The invention will now be described with reference to a preferred embodiment which is shown in the enclosed drawings. In the drawings,
- Figure 1 schematically shows a housing according to the invention in a perspective view;
- Figure 2 shows part of the housing of Figure 1 at an enlarged scale, and
- Figure 3 shows a lateral view of a wall element employed in the housing of Figure 1.

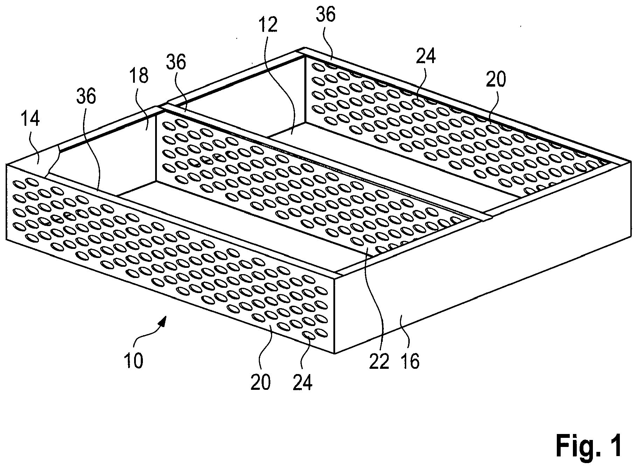

In Figure 1, a housing 10 for an electronic apparatus is schematically shown. Housing 10 has a bottom wall 12, a top wall 14 (shown only partially in order to allow a view into the interior of the housing), and wall elements extending between the bottom wall 12 and the top wall 14. For ease of reference, these are referred to in the following as a front wall 16, a rear wall 18 and two side walls 20.

An additional intermediate wall 22 is arranged in the interior of housing 10 in order to form separate compartments and/or to reinforce the housing. Wall 22 is optional.

Housing 10 is intended to accommodate an electronic apparatus which has a significant weight and significant heat dissipation. Furthermore, housing 10 is intended for field use, for example at construction sites, outside of buildings and at frequently changing locations. This results in a couple of requirements.

A first requirement is that ambient air has to be able to enter into the housing and exit from the housing in order to discharge the heat from the electronic apparatus. To this end, at least one of the wall elements which form the housing (bottom wall 12, top wall 14, front wall 16, rear wall 18 and side walls 20) or are arranged within the housing (intermediate wall 22) is provided with many openings 24 through which air can pass.

In the following, the openings 24 will be described with reference to the embodiment of Figures 1 to 3 in which they are provided in wall elements 20, 22. It should be understood that the openings can either in addition or alternatively be provided in the bottom wall 12, the top wall 14, the front wall 16 and/or the rear wall 18, and the following comments made with respect to the wall elements 20, 22 equally apply to wall elements 12, 14, 16, 18 if these are provided with openings 24.

It can be seen in Figure 1 that the percentage of the combined cross-section of the openings 24 as compared to the entire surface of the wall elements 20, 22 is significant.

A second requirement is that the housing has to have a high rigidity so as to provide a mechanical protection for the electronic apparatus and to confer a high rigidity of the housing. In view of the openings 24, the resistance to torsional loads tending to twist housing 10 around an axis which is perpendicular to the plane in which wall elements 22 extend, is a key factor in this regard.

In order to combine a good permeability to cooling air while at the same time maintaining the ability to carry high shear loads as is necessary for a high torsional rigidity, openings 24 in wall elements 20, 22 are arranged and dimensioned in a particular manner.

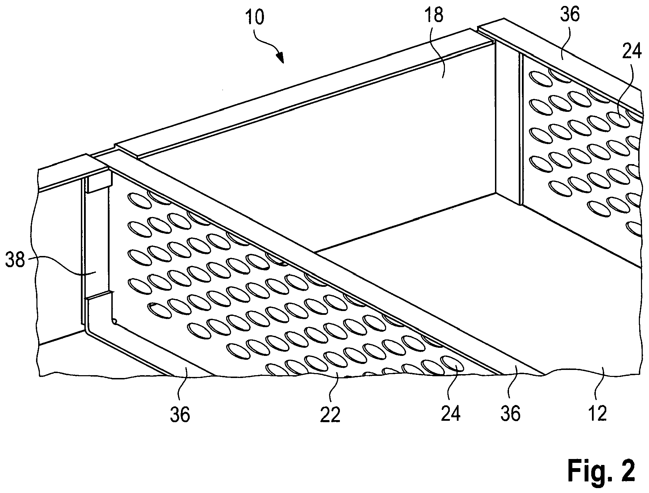

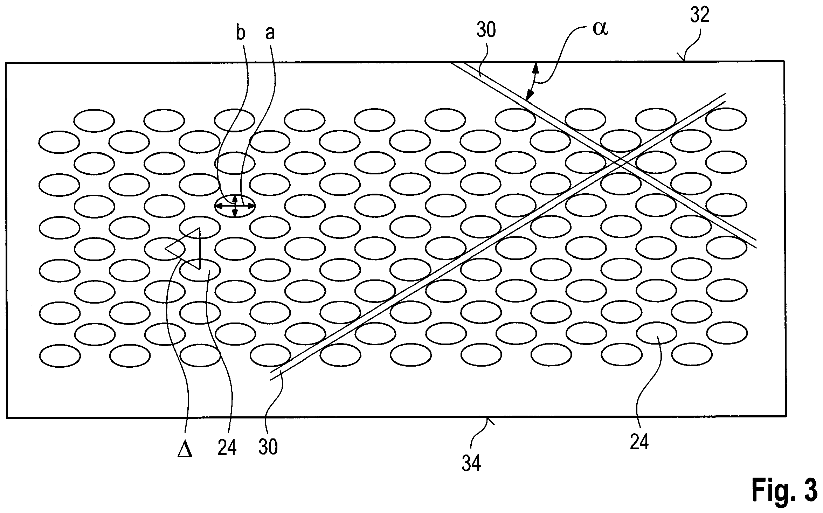

Each opening has the contour (or shape) of an ellipse, as can be seen in Figures 2 and 3. The length of the semi-major axis a is twice the length of the semi-minor axis b (please see Figure 3).

Further, the distance s between the centers of adjacent ellipses is twice the length of the semi-major axes of the ellipses. The centers of adjacent ellipses are arranged so as to define an isosceles triangle, the legs of the triangle having the length s.

The result of these dimensions of the ellipses and of the positions of the ellipses with respect to adjacent ones is that a plurality of straight, continuous load paths are being formed on each wall element 20, 22. Two of these load paths are identified in Figure 3 with reference numeral 30 and extend from an upper edge 32 of wall elements 20, 22 to a lower edge 34, or vice-versa.

The load paths extend obliquely with respect to the upper and lower edges 32, 34 of wall elements 20, 22. The angle α with which the load paths are arranged with respect to the upper and lower edges of the wall elements is approx 30°. Accordingly, the angle enclosed between intersecting load paths is approx. 120° (or 60°, depending at which side the angle is being measured).

Each load path is a succession of portions of the material of the wall elements 20, 22 with different widths. The important point is that towards the narrowest portions, namely the portions between diagonally adjacent elliptic openings 24, the contour of the openings is smoothly curved so that there is no sudden variation of the available cross-section of the material of the wall elements available for load transmission and consequently no stress concentration.

The upper and lower edges 32, 34 of each wall element are bent by 90° with respect to the main portion of each wall element 20, 22 (please see in particular Figure 2) so that laterally extending legs 36 are being formed. Wall elements 20, 22 thus form a girder with a U-shaped cross-section. Legs 36 can be attached to bottom 12 and top 14 or can simply provide a support therefor.

At the lateral edges of the wall elements, legs 38 can be provided which also extend at an angle of 90° with respect to the central body portion of wall elements 20, 22 (please see in particular Figure 2). Legs 38 are being used for mechanically connecting the lateral walls of wall elements 20, 22 to front wall 16 and rear wall 18 of housing 10.

The housing and in particular the wall elements 20, 22 are preferably made from sheet metal. Thus, the openings 24 can be punched or cut from a sheet metal blank, and the legs 36, 38 can be formed by bending.

Housing 10 can be equipped with a single wall element 20, or a wall element provided with the openings 24 can also be used for the front wall 16 or the rear wall 18.

It is also possible to use more than one wall element 22 in the interior of the housing, if desired.

Instead of openings 24 which have a strictly elliptical contour, openings formed from other curves can be used as well, for example formed from parabolic curves. In any case, the contour of the openings has to resemble an elliptic shape so as to achieve the load paths between the openings.

As compared to a housing using wall elements having circular or hexagonal openings which provide the same total cross-section for cooling air, housing 10 provided with wall elements 20, 22 offers an increase of the rigidity against torsional loads by approx. 50%.

## Claims

1. A housing (10) for an electronic apparatus, having a bottom wall (12), a top wall (14) and at least one side wall (16, 18, 20, 22) extending between the bottom wall (12) and the top wall (14), at least one of the wall elements (12, 14, 16, 18, 20, 22) having a plurality of vent openings (24), **characterized in that** the vent openings (24) having a generally elliptical shape and being arranged such that a plurality of straight, uninterrupted load paths (30) is being formed which extend from an upper edge (32) of the wall element (12, 14, 16, 18, 20, 22) to a lower edge (34) thereof in a direction which is oriented obliquely with respect to the upper and the lower edge (32, 34), respectively.

2. The housing (10) of claim 1 wherein the upper edge and the lower edge (32, 34) of the wall element (20, 22) are provided with legs (36) which extend at generally 90° with respect to a central body portion of the wall element (20, 22) so as to form a U-shaped girder.

3. The housing (10) of claim 1 or claim 2 wherein the wall element has legs (38) at the lateral edges, the legs (38) extending at generally 90° with respect to a central body portion of the wall element (20, 22).

4. The housing (10) of any of the preceding claims wherein the total cross-section of the openings (24) amounts to at least 30% of the surface of the wall element (20, 22).

5. The housing (10) of any of the preceding claims wherein the load paths (30) extend at an angle (α) of approx. 30° with respect to the upper and lower edges (32, 34), respectively.

6. The housing (10) of any of the preceding claims wherein the contour of the openings (24) is a continuous one.

7. The housing (10) of claim 6 wherein the contour comprises at least one parabolic arc.

8. The housing (10) of claim 6 wherein the contour is an ellipse.

9. The housing (10) of claim 8 wherein the length of the semi-major axis (a) is twice the length of the semi-minor axis (b), and the distance (s) between adjacent openings (24) being twice the length of the semi-major axis (a).

10. The housing (10) of any of the preceding claims wherein the wall element (20, 22) is made from sheet metal.

11. Wall element (12, 14, 16, 18, 20, 22) for a housing as defined in any of the preceding claims.

## Patentansprüche

1. Gehäuse (10) für eine elektronische Vorrichtung, das eine Bodenwand (12), eine obere Wand (14) und mindestens eine Seitenwand (16, 18, 20, 22), die zwischen der Bodenwand (12) und der oberen Wand (14) verläuft, aufweist, wobei mindestens eins der Wandelemente (12, 14, 16, 18, 20, 22) mehrere Be- und Entlüftungsöffnungen (24) aufweist, **dadurch gekennzeichnet, dass** die Be- und Entlüftungsöffnungen (24) eine im Allgemeinen elliptische Form aufweisen und so angeordnet sind, dass mehrere gerade, ununterbrochene Lastpfade (30) ausgebildet werden, die von einer Oberkante (32) des Wandelements (12, 14, 16, 18, 20, 22) zu einer Unterkante (34) davon in einer Richtung verlaufen, die bezogen auf die Ober- beziehungsweise Unterkante (32, 34) schräg ausgerichtet ist.

2. Gehäuse (10) nach Anspruch 1, wobei die Oberkante und die Unterkante (32, 34) des Wandelements (20, 22) mit Schenkeln (36) versehen sind, die unter im Allgemeinen 90° bezogen auf einen mittigen Körperabschnitt des Wandelements (20, 22) verlaufen und so einen U-förmigen Träger bilden.

3. Gehäuse (10) nach Anspruch 1 oder Anspruch 2, wobei das Wandelement Schenkel (38) an den Seitenkanten aufweist, wobei die Schenkel (38) unter im Allgemeinen 90° bezogen auf einen mittigen Körperabschnitt des Wandelements (20, 22) verlaufen.

4. Gehäuse (10) nach einem der vorhergehenden Ansprüche, wobei der Gesamtquerschnitt der Öffnungen (24) mindestens 30% der Oberfläche des Wandelements (20, 22) beträgt.

5. Gehäuse (10) nach einem der vorhergehenden Ansprüche, wobei die Lastpfade (30) unter einem Winkel (α) von ungefähr 30° bezogen auf die Oberkante beziehungsweise Unterkante (32, 34) verlaufen.

6. Gehäuse (10) nach einem der vorhergehenden Ansprüche, wobei der Umriss der Öffnungen (24) durchgehend ist.

7. Gehäuse (10) nach Anspruch 6, wobei der Umriss mindestens einen Parabelbogen umfasst.

8. Gehäuse (10) nach Anspruch 6, wobei der Umriss eine Ellipse ist.

9. Gehäuse (10) nach Anspruch 8, wobei die große Halbachse (a) doppelt so lang wie die kleine Halbachse (b) ist und der Abstand (s) zwischen benachbarten Öffnungen (24) doppelt so groß ist wie die Länge der großen Halbachse (a).

10. Gehäuse (10) nach einem der vorhergehenden Ansprüche, wobei das Wandelement (20, 22) aus Blech gefertigt ist.

11. Wandelement (12, 14, 16, 18, 20, 22) für ein Gehäuse nach einem der vorhergehenden Ansprüche.

## Revendications

1. Boîtier (10) pour un appareil électronique, présentant une paroi de fond (12), une paroi supérieure (14) et au moins une paroi latérale (16, 18, 20, 22) qui s'étend entre la paroi de fond (12) et la paroi supérieure (14), au moins l'un des éléments de paroi (12, 14, 16, 18, 20, 22) présentant plusieurs orifices d'aération (24), **caractérisé en ce que** les orifices d'aération (24) ont une forme généralement elliptique et sont agencés de telle sorte que plusieurs trajets de charge (30) rectilignes et ininterrompus sont formés, lesquels s'étendent depuis un bord supérieur (32) de l'élément de paroi (12, 14, 16, 18, 20, 22) vers un bord inférieur (34) de celui-ci dans un sens qui est orienté en oblique par rapport au bord supérieur et inférieur (32, 34), respectivement.

2. Boîtier (10) selon la revendication 1, le bord supérieur et le bord inférieur (32, 34) de l'élément de paroi (20, 22) étant pourvus de branches (36) qui s'étendent généralement sous un angle de 90° par rapport à un tronçon de corps central de l'élément de paroi (20, 22) de manière à former un support en forme de U.

3. Boîtier (10) selon la revendication 1 ou la revendication 2, l'élément de paroi présentant des branches (38) sur les bords latéraux, les branches (38) s'étendant généralement sous un angle de 90° par rapport à un tronçon de corps central de l'élément de paroi (20, 22).

4. Boîtier (10) selon l'une des revendications précédentes, la section transversale totale des orifices (24) s'élevant à au moins 30 % de la surface de l'élément de paroi (20, 22).

5. Boîtier (10) selon l'une des revendications précédentes, les trajets de charge (30) s'étendant sous un angle (α) d'environ 30° par rapport au bord supérieur et inférieur (32, 34), respectivement.

6. Boîtier (10) selon l'une des revendications précédentes, le contour des orifices (24) étant un contour continu.

7. Boîtier (10) selon la revendication 6, le contour comprenant au moins un arc parabolique.

8. Boîtier (10) selon la revendication 6, le contour étant une ellipse.

9. Boîtier (10) selon la revendication 8, la longueur du demi-grand axe (a) correspondant au double de la longueur du demi-petit axe (b), et la distance (s) entre des ouvertures adjacentes (24) correspondant au double de la longueur du demi-grand axe (a).

10. Boîtier (10) selon l'une des revendications précédentes, l'élément de paroi (20, 22) étant en tôle.

11. Élément de paroi (12, 14, 16, 18, 20, 22) pour un boîtier selon l'une des revendications précédentes.
